# EUROPEAN PATENT APPLICATION

(11) **EP 4 120 377 A1**
(43) Date of publication of application: **18.01.2023**
(21) Application number: 21306006.4
(22) Date of filing: 16.07.2021
(51) Int. Cl.: H01L 49/02, H01L 29/94, H01L 21/04, H01L 29/66

(54) **DIAMOND-BASED CAPACITOR STRUCTURE**

(71) Applicant: Murata Manufacturing Co., Ltd., Nagaokakyo-shi, Kyoto 617-8555 (JP); Commissariat à l'énergie atomique et aux énergies alternatives, 75015 Paris (FR)
(72) Inventor: BUFFLE, Larry, 38000 GRENOBLE (FR); VOIRON, Frédéric, 38530 BARRAUX (FR); POMORSKI, Michal, 91191 Gif-sur-Yvette Cedex (FR)
(74) Representative: Cabinet Beau de Loménie

(57) **Abstract**

A diamond-based capacitor structure is disclosed. The capacitor structure comprises a single-crystal diamond layer; a first graphite layer buried into the single-crystal diamond layer, the first graphite layer providing a first electrode of the capacitor structure; and a second graphite layer buried into the single-crystal diamond layer above the first graphite layer, the second graphite layer providing a second electrode of the capacitor structure.

## Description

### Field of the Invention

The present invention relates to the field of integration and, more particularly, to electronic products, related semiconductor products, and their methods of manufacture.

### Technical Background

In the emerging field of high-voltage capacitor applications (e.g., operating/breakdown voltages from around 500 V to greater than 1 kV), a main concern is preventing early fails and/or premature wear out of the capacitor device due to the high voltage operation. This concern means that the operating electric field must be guaranteed with a sufficient margin for the desired lifetime of the device.

One way to sustain the operating electrical field is by increasing the thickness of the dielectric layer (typically a silicon-based material) used in the capacitor. However, the increase of the dielectric thickness brings various challenges as discussed below.

In one aspect, it is known that to obtain optimal (e.g., intrinsic) dielectric properties, the dielectric layer should be deposited at high temperatures (e.g., above 600° Celsius). Generally, however, this results in an increase of mechanical stress in the structure when the wafer is then cooled down to ambient temperature. With the use of a thicker dielectric layer, this problem is exacerbated, leading to cracks and/or delamination being observed in the dielectric layer. These cracks and/or delamination not only introduce weak points in the dielectric layer but can also generate a great amount of particles that may contaminate cleanroom deposition tools. In extreme cases, the mechanical stress in the structure can be so high as to cause severe deformation in the wafer to the point that the wafer can no longer be transported by automatic robotic handlers.

In another aspect, the increase of dielectric thickness increases electrical stress within the structure (particularly when the structure is made three-dimensional to increase capacitance density) which impacts the long-term robustness of the dielectric. Specifically, it is known that, in a 3D trench capacitor structure, the electrostatic field exhibits magnitude peaks at singular points (e.g., sharp corners) of the electrode geometry. The increase of the thickness of the dielectric causes even greater electrostatic field concentrations at the singular points, resulting in faster dielectric wear out and/or earlier breakdown.

The conventional solution of increasing the dielectric thickness, especially of a silicon-based dielectric material, has thus clear limitations and can be at odds with the objectives of increasing device reliability and capacitance density, particularly for high-voltage capacitor applications.

### Summary of the Invention

The present invention provides a capacitor structure, comprising:
a single-crystal diamond layer;
a first graphite layer buried into the single-crystal diamond layer, the first graphite layer providing a first electrode of the capacitor structure; and
a second graphite layer buried into the single-crystal diamond layer, above the first graphite layer, the second graphite layer providing a second electrode of the capacitor structure.

As such, the capacitor structure is provided by a monolithic, single material structure, which provides both the electrodes and the dielectric layer of the capacitor.

In an embodiment, the single-crystal diamond layer consists of intrinsic (i.e., non-doped) diamond. As such, the capacitor structure exploits the dielectric-like state of intrinsic diamond to provide dielectric layers of comparable performance (in terms of breakdown field, leakage current, permittivity, and predictability) to conventional silicon-based dielectric layer (e.g., silicon dioxide). In parallel, the structure leverages the conductivity obtained by graphitizing diamond to provide conductive electrodes for the capacitor structure.

The formation of the capacitor structure from a monolithic, single material structure eliminates the need to deposit a dielectric of a different material than the capacitor electrodes. As such, mechanical stress within the structure can be significantly reduced and the potential for cracks and/or delamination forming in the dielectric is eliminated.

The use of single-crystal diamond enhances the mechanical, thermal, and electrical properties of the diamond layer. Specifically, the absence of grain boundaries and the low density of defects (typically less than 1000 defects/cm²) in single-crystal diamond reduce the potential for leakage through the diamond, making for an excellent dielectric.

In an embodiment, the capacitor structure may further comprise a substrate supporting the single-crystal diamond layer.

In an embodiment, the substrate is conductive and electrically connected to the first graphite layer or to the second graphite layer. As such, the substrate forms part of the capacitor structure and contributes in combination with the first graphite or the second graphite layer a further capacitance to the capacitor structure.

The substrate may be a silicon-based substrate, a gallium nitride substrate, or a diamond substrate, for example.

In an embodiment, the first graphite layer and the second graphite layer are planar.

In another embodiment, the first graphite layer and second graphite layer are textured.

In an embodiment, the single-crystal diamond layer may comprise an epitaxial diamond layer. The second graphite layer may be at least partially buried into the epitaxial diamond layer.

In an embodiment, the capacitor structure further comprises a third graphite layer buried into the single-crystal diamond layer above the second graphite layer; and a fourth graphite layer buried into the single-crystal diamond layer above the third graphite layer. The third graphite layer may be electrically connected to the first graphite layer and the fourth graphite layer may be electrically connected to the second graphite layer. As such, parallel-coupled capacitors may be formed respectively between the first graphite layer and the second graphite layer, between the second graphite layer and the third graphite layer, and between the third graphite layer and the fourth graphite layer, with the single-crystal diamond acting as dielectric for each capacitor.

In another embodiment, the first graphite layer and the fourth graphite layer may be electrically connected. As such, the capacitors formed between the first graphite layer and the second graphite layer, between the second graphite layers and the third graphite layer, and between the third graphite layer and the fourth graphite layer are coupled in series.

In another aspect, the present invention provides a capacitor structure, comprising:
a single-crystal diamond layer;
a graphite layer buried into the single-crystal diamond layer, the graphite layer providing a first electrode of the capacitor structure; and
a conductive substrate supporting the single-diamond layer providing a second electrode of the capacitor structure.

In a further aspect, the present invention provides a method of fabricating a capacitor structure, comprising:
implanting first ions into a first single-crystal diamond layer to form a first graphite layer inside the first single-crystal diamond layer;
subjecting the ion-implanted first single-crystal diamond layer to an annealing process;
epitaxially growing a second single-crystal diamond layer on top of the first single-crystal diamond layer; and
implanting second ions into first single-crystal diamond layer and/or the second single-crystal diamond layer to form a second graphite layer inside the first single-crystal diamond layer (104) and/or the second single-crystal diamond layer.

In an embodiment, the annealing process comprises subjecting the ion-implanted first single-crystal diamond layer to a temperature of at least 1100°C. The annealing duration may be of a few hours.

The annealing process has the effect of inducing each of the phases (i.e., the single-crystal diamond and the graphite) within the diamond layer to try to reduce its intrinsic entropy. As such, the single-crystal diamond tends to return to ideal single-crystal diamond phase by eliminating defects and the graphite tends to increase its disorder thereby approaching ideal graphite phase. This has the double advantage of reducing leakage and enhancing the dielectric properties of the ion-implanted single-crystal diamond layer as well as of increasing the conductivity of the formed graphite layer.

The use of homoepitaxial growth bonds by the sides the second single-crystal diamond layer to the first single-crystal diamond crystal. As there is no interface (no crystalline mismatch) in the bonding area, the two layers strongly bond together and share a common thermomechanical behavior. In terms of performance, they can be considered as one single mono-crystalline element, sealing one or more graphitized areas.

In yet another aspect, the present invention provides a method of fabricating a capacitor structure, comprising:
forming a first mask layer over a first end region of a first single-crystal diamond layer;
implanting first ions, using a first energy level, into the first single-crystal diamond layer to form a first graphite layer inside the first single-crystal diamond layer;
implanting second ions, using a second energy level lower than the first energy level, into the first single-crystal diamond layer to form a second graphite layer, above the first graphite layer, inside the first single-crystal diamond layer; and
electrically connecting the first graphite layer and the second graphite layer.

In an embodiment, the method comprises comprising subjecting the ion-implanted first single-crystal diamond layer to an annealing process. The annealing may be performed after each ion implantation step. Alternatively, a single annealing step may be performed after forming the first and second graphite layers.

In an embodiment, the method may further comprise:
forming a second mask layer over a second end region of the first single-crystal diamond layer, the second end region being at an opposite end of the capacitor structure relative to the first end region;
implanting third ions, using a third energy level lower than the first energy level and higher than the second energy level, into the first single-crystal diamond layer to form a third graphite layer, above the first graphite layer and below the second graphite layer, inside the first single-crystal diamond layer; and
implanting fourth ions, using a fourth energy level lower than the second energy level, into the first single-crystal diamond layer to form a fourth graphite layer, above the second graphite layer, inside the first single-crystal diamond layer.

### Brief Description of the Drawings

Further features and advantages of the present invention will become apparent from the following description of certain embodiments thereof, given by way of illustration only, not limitation, with reference to the accompanying drawings in which:
FIG. 1 illustrates a capacitor structure according to a first embodiment;
FIGs. 2A-2K illustrate an example process that may be used to fabricate the capacitor structure according to the first embodiment;
FIGs. 3A-3B illustrate process steps that may be used to fabricate the capacitor structure according to the first embodiment;
FIG. 4 illustrates a capacitor structure according to a second embodiment;
FIG. 5A-5J illustrate an example process that may be used to fabricate the capacitor structure according to the second embodiment;
FIG. 6 is a scanning electron microscopy (SEM) image showing a single-crystal diamond structure with a graphite layer buried therein by ion implantation;
FIG. 7 illustrates the effect of the application of an annealing process on the dielectric properties of the single-crystal diamond structure of FIG. 6; and
FIG. 8 illustrates the effect of the application of an annealing process on the resistance of the graphite layer buried in the single-crystal diamond structure of FIG. 6.

### Detailed Description of Example Embodiments

As further described below, embodiments of the present invention address the existing deficiencies of the prior art by proposing diamond-based capacitor structures.

The proposed structures exploit the dielectric-like state of intrinsic diamond to provide dielectric layers of comparable performance (in terms of breakdown field, leakage current, permittivity, and predictability) to conventional silicon-based dielectric layer (e.g., silicon dioxide). In parallel, the structures leverage the conductivity obtained by graphitizing diamond to provide the conductive electrodes for the structures.

As such, the proposed capacitor structures can be formed from a monolithic, single material structure, which provides both the conductive and the dielectric components of the capacitor. In particular, by eliminating the need to deposit the dielectric as a different material than the capacitor electrodes, mechanical stress within the structure can be significantly reduced and the potential for cracks and/or delamination forming in the dielectric is eliminated.

Moreover, as diamond can be deposited in thick layers (e.g., from hundreds of nanometers up to tens of microns, a single material deposition would be sufficient to obtain a multi-layer capacitor with relatively thick (e.g., 1.5-2 microns) dielectric layers to support high-voltage applications.

The proposed structures may be formed from single-crystal diamond. As such, improved mechanical and electrical properties are achieved. Specifically, the absence of grain boundaries and the low density of defects (typically less than 1000 defects/cm²) in single-crystal diamond reduce the potential for leakage through the diamond, making for an excellent dielectric.

In another aspect, the high thermal conductivity of diamond means that the proposed structures can act as heat transfer mediums for other less heat-tolerant circuits. Cooling requirements may thus be reduced, increasing circuit packaging efficiency. In particular, the proposed structures may be used in support of high temperature applications, such as automotive applications, for example.

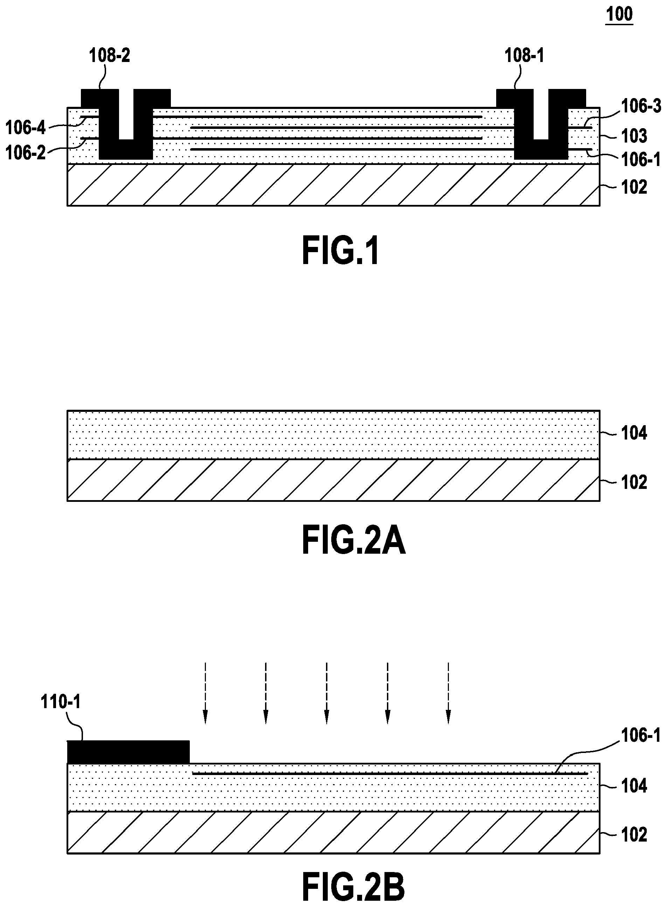

FIG. 1 illustrates a capacitor structure 100 according to a first embodiment. As shown in FIG. 1, capacitor structure 100 may include a substrate 102, a single-crystal diamond layer 103, a plurality of graphite layers 106 buried into the single-crystal diamond layer 103, and first and second electrode contacts 108.

Substrate 102 may be silicon-based substrate (e.g., silicon, silicon carbide, etc.), a diamond substrate, or a gallium nitride (GaN) substrate, for example. In another embodiment, capacitor structure 100 may not include a substrate 102.

Single-crystal diamond layer 103 may include one or more layers of monocrystalline diamond. Some of the layers may be layers that are grown on top of an initial single-crystal diamond. In an embodiment, diamond layer 103 consists of intrinsic (i.e., non-doped) diamond.

In an embodiment, where substrate 102 is other than diamond, a buffer layer (e.g., SiC, Iridium) may be provided between substrate 102 and diamond layer 103.

As shown in FIG. 1, graphite layers 106 are formed into the single-crystal diamond layer 103 at respective depths and are substantially planar. The depth at which a graphite layer 106 is formed is a function of the energy used during ion implantation (discussed further below). In implementation, a graphite layer 106 comprises multiple atomic planes. Specifically, the atomic planes of the graphite layer 106 may be characterized by a Gaussian distribution having an average depth Rp and a standard deviation ΔRp. The resulting standard deviation ΔRp of a graphite layer 106 reflects its thickness and amorphization level, which in turn determine its conductivity. Particularly, the thicker and the more amorphous the graphite layer 106 is, the more conductive it is.

As shown in FIG. 1, the single-crystal diamond intervenes between successive graphite layers 106. With the single-crystal diamond being insulating, capacitors may be formed between any two graphite layers.

For example, as shown in FIG. 1, the first electrode contact 108-1 may be coupled to graphite layers 106-1 and 106-3, and the second electrode contact 108-2 may be coupled to graphite layers 106-2 and 106-4. As such, parallel-coupled capacitors may be formed respectively between graphite layers 106-1 and 106-2, between graphite layers 106-2 and 106-3, and between graphite layers 106-3 and 106-4, with the single-crystal diamond acting as dielectric for each capacitor.

Embodiments however are not limited to this particular configuration. For instance, according to another example configuration, the first electrode contact 108-1 may be coupled to only graphite layer 106-1, and the second electrode contact 108-2 may be coupled to only graphite layer 106-4. As such, the capacitors formed between graphite layers 106-1 and 106-2, between graphite layers 106-2 and 106-3, and between graphite layers 106-3 and 106-4 may be coupled in series.

In an embodiment, substrate 102 of capacitor structure 100 may be conductive. As such, substrate 102 may be interconnected to one or more of the graphite layers 106 and/or may be used to provide an electrode of the capacitor structure 100 (not shown in FIG. 1). For example, in an embodiment, a capacitor structure may be formed using a single graphite layer (e.g., 106-1) providing the first electrode and the conductive substrate 102 providing the second electrode of the capacitor structure.

FIGs. 2A-2K illustrate an example process that may be used to fabricate the capacitor structure 100 described above.

The process begins, as shown in FIG. 2A, by forming a first single-crystal diamond layer 104 on top of a substrate 102.

As mentioned before, the substrate 102 may be silicon-based substrate (e.g., silicon, silicon carbide, etc.), a diamond substrate, or a gallium nitride (GaN) substrate, for example. In an embodiment, when the substrate 102 is other than diamond, a buffer layer may be provided between the substrate 102 and the diamond layer 104.

Without limitation, diamond layer 104 may be what is known as "pristine CVD" diamond or HPHT (high pressure, high temperature) diamond.

Subsequently, as shown in FIG. 2B, a first mask layer 110-1 may optionally be formed to cover a first end region of the diamond layer 104, and an ion implantation process is performed to implant first ions (e.g., hydrogen, helium, or carbon) into the diamond layer 104 to form a first graphite layer 106-1 inside the diamond layer 104. The first mask layer 110-1 may be made of any material that can be deposited without damaging the diamond layer 104 (e.g., a deposition process at below 500°C in an oxidizing environment or not requiring an oxidizing environment). For example, the first mask layer 110-1 may be made of a polymer, silicon nitride, or even a metal, to name a few examples.

In the implantation process, the ions are accelerated at high energy (e.g., 100-300 keV) into the diamond layer 104. When they impinge on carbon atoms in the diamond layer 104, the ions cause a change in the covalent bond configuration of the carbon atoms. Specifically, the covalent bond configuration changes from sp³ orbital hybrids to sp² orbital hybrids. At a certain level of amorphization, planes (which together form graphite layer 106-1) start to form in the diamond layer 104. Within each plane, carbon atoms are bonded covalently but one electron remains free to migrate in the plane. This leads to the formed graphite layer 106-1 being amenable to electrical conduction.

As mentioned above, the depth at which graphite layer 106-1 is formed depends on the implantation energy used in the ion implantation process. This energy corresponds to the energy at which the ions are accelerated into the diamond layer 104. In an embodiment, the implantation energy is adapted so that the graphite layer 106-1 is formed about 0.5-1 microns into the diamond layer 104. Depending on the energy class of the used accelerator, a masking layer (e.g., a polymer, such as silicon nitride) or a recess in the diamond layer 104 may be used, if necessary, to modulate the implant depth.

As the ions get implanted into the diamond layer 104, they cause defects in the diamond layer 104 in the region above the formed graphite layer 106-1. This changes the electrical characteristics of this region, particularly increasing leakage current through this region.

In an embodiment, the process may include, after the ion implantation process, an annealing process to heal the damage caused by the ion implantation. In an embodiment, the annealing process is a high-temperature process (e.g., at a temperature greater than 1100°C).

The annealing process has the effect of inducing each of the phases (i.e., the single-crystal diamond and the graphite) within the diamond layer 104 to try to reduce its intrinsic entropy. As such, the single-crystal diamond tends to return to ideal single-crystal diamond phase by eliminating defects and the graphite tends to increase its disorder thereby approaching ideal graphite phase.

In the capacitor structure 100, this has the double advantage of reducing leakage and enhancing the dielectric properties of the ion-implanted single-crystal diamond layer 104 as well as of increasing the conductivity of the formed graphite layer 106-1.

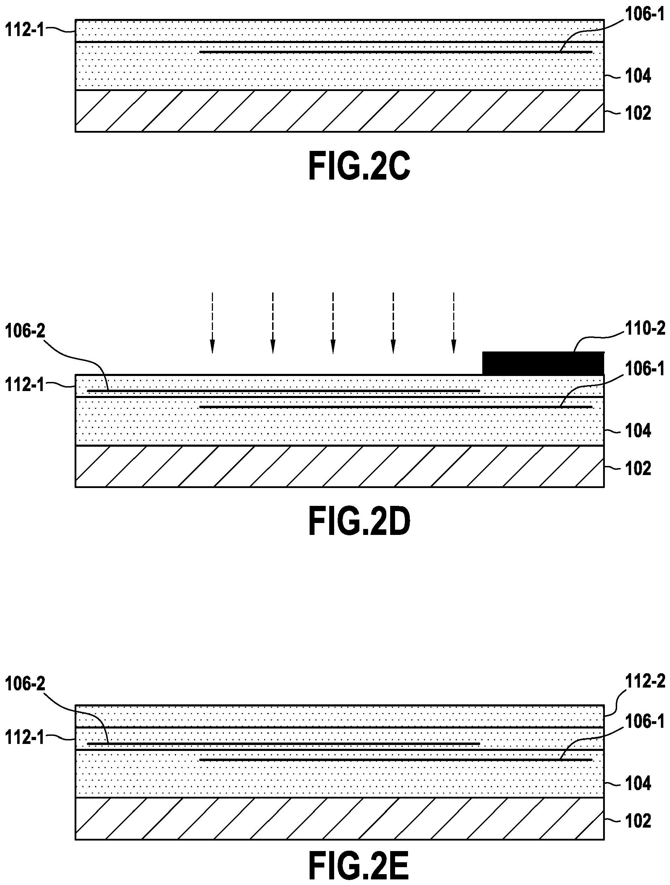

Next, as shown in FIG. 2C, the process includes epitaxially growing a second single-crystal diamond layer 112-1 on top of the first single-crystal diamond layer 104. In an embodiment, the performed epitaxy is a CVD (chemical vapor deposition)-based homoepitaxy that results in the growth of an intrinsic diamond film above the first single-crystal diamond layer 104. In practice, the grown second diamond layer 112-1 may be of comparable quality (and even of superior quality if process conditions allow it) to the pristine diamond layer 104.

It is noted herein that a further benefit of the annealing process described above is facilitating the epitaxy step by allowing recovery of surface lattice geometry.

Subsequently, as shown in FIG. 2D, a second mask layer 110-2 may optionally be formed to cover a second end region of the second diamond layer 112-1, and an ion implantation process is performed to implant second ions (e.g., hydrogen, helium, or carbon) into first single-crystal diamond layer 104 and/or the second single-crystal diamond layer 112-1 to form a second graphite layer 106-2 inside the first single-crystal diamond layer 104 and/or the second single-crystal diamond layer 112-1. The second mask layer 110-2 may be similar to the first mask layer 110-1 described above.

In an embodiment, as shown in FIG. 2D, the second end region of the second single-crystal diamond layer 112-1 that is covered by the second mask layer 110-2 is at the opposite end of the capacitor structure relative to the first end region of the first single-crystal diamond layer 104 covered by first mask layer 110-1 (shown in FIG. 2B). This mask configuration allows for the formed graphite layers 106-1 and 106-2 to be shifted to opposite sides of the structure as shown in FIG. 2D. As further described below, this facilitates electrically connecting the graphite layers 106 in a parallel capacitor configuration.

The process may then continue as shown in FIGs. 2E-2H to form further graphite layers 106 in the structure.

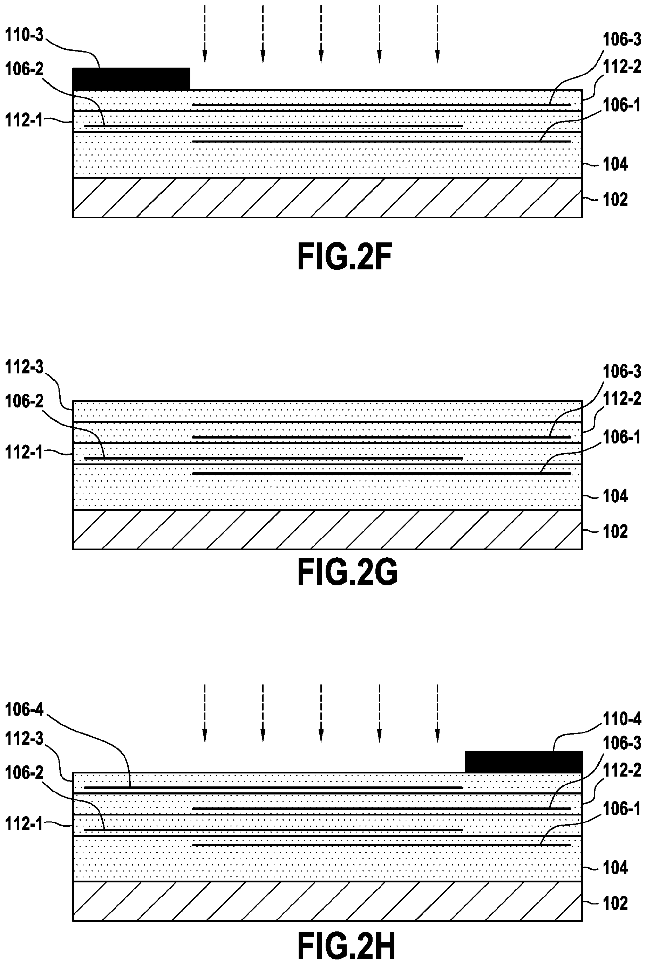

Specifically, after an optional annealing step as described above, a third single-crystal diamond layer 112-2 may be epitaxially grown above the second diamond layer 112-1 as shown in FIG. 2E, and a third graphite layer 106-3 may then be formed by ion implantation inside the second diamond layer 112-1 and/or the third diamond layer 112-2 as shown in FIG. 2F.

An optional third mask layer 110-3 may be used in the formation of third graphite layer 106-3. The third mask layer 110-3 may be identical in shape and relative positioning to the first mask layer 110-1 used in forming the first graphite layer 106-1. As such, the third graphite layer 106-3 is formed as if an upward vertical projection of the first graphite layer 106-1 onto an upper plane within the diamond layers.

The same process (annealing, epitaxy, and ion implantation) may then be repeated as shown in FIGs. 2G and 2H to form a fourth graphite layer 106-4 inside a further epitaxially-grown fourth diamond layer 112-3 and/or the third diamond layer 112-2.

An optional fourth mask layer 110-4 may be used in the formation of fourth graphite layer 106-4. The fourth mask layer 110-4 may be identical in shape and relative positioning to the second mask layer 110-2 used in forming the second graphite layer 106-2. As such, the fourth graphite layer 106-4 is formed as if an upward vertical projection of the second graphite layer 106-2 onto an upper plane within the diamond layers.

As would be understood by a person of skill in the art based on the teachings herein, the process (annealing, epitaxy, ion implantation) may be repeated any number of times to form further graphite layers in parallel planes of the single-crystal diamond.

The formed graphite layers 106 may be interconnected in a variety of configurations as would be understood by a person of skill in the art.

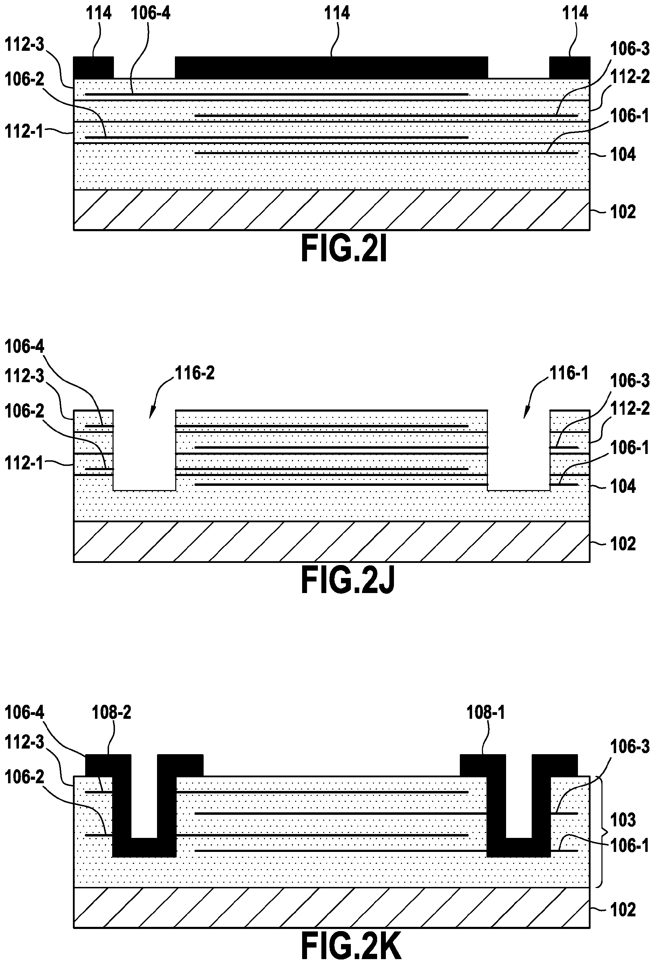

In an embodiment, as illustrated in FIG. 1, the graphite layers 106 may be connected to form a parallel capacitor configuration. Example process steps for implementing this particular configuration are shown in FIGs. 2I, 2J, and 2K. Specifically, they may include forming a mask layer 114 (which may be similar to the first mask layer 110-1 described above) having openings at either end of the capacitor structure (FIG. 2I); etching through the diamond layers (112-3, 112-2, 112-1, and 104) and the intervening graphite layers (106-4, 106-3, 106-2, and 106-1) at the mask openings to form notches 116-1 and 116-2 (FIG. 2J); and forming first and second electrode contacts 108-1 and 108-2 in the notches 116.

In an embodiment, the mask layer 114 may be configured such that the first electrode contact 108-1 contacts only the first graphite layer 106-1 and the third graphite layer 106-3, and such that the second electrode contact 108-2 contacts only the second graphite layer 106-2 and the fourth graphite layer 106-4. This interconnection is facilitated by the shifted positioning of each of the graphite layers 106, to one side or the other of the structure, as described above.

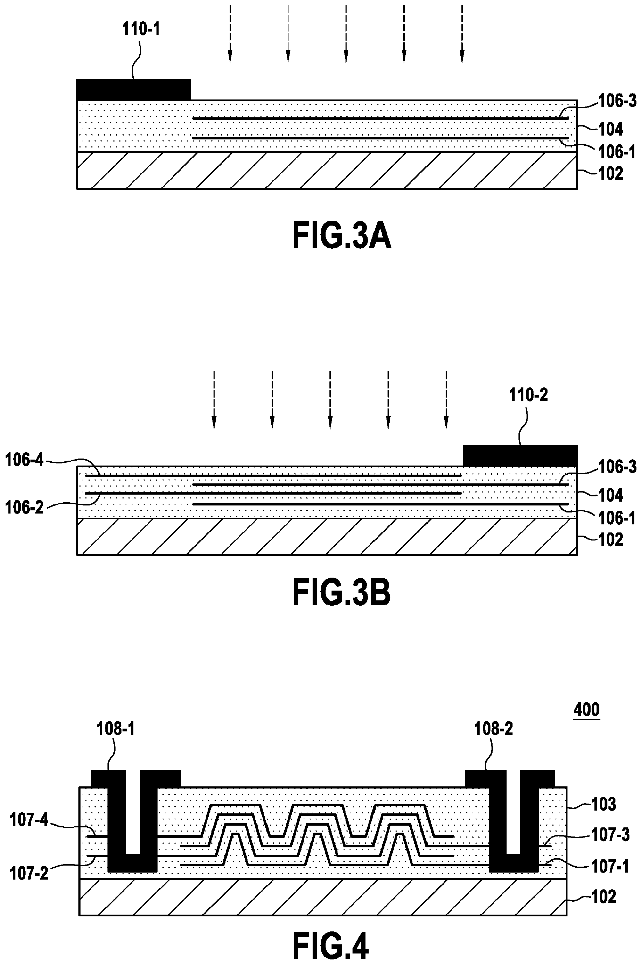

In another embodiment, the process described above for fabricating the capacitor structure 100 may be modified so that graphite layers providing an electrode of the same polarity are formed together in the same process steps. Specifically, as shown in FIGs. 3A and 3B, the process may include successively forming graphite layers 106-1 and 106-3, followed by successively forming graphite layers 106-2 and 106-4 inside single-crystal diamond layer 104.

To ensure proper implant depths for the graphite layers, the implantation energy is controlled appropriately for each graphite layer.

In an embodiment, annealing as described above may be performed after each ion implantation process. Such annealing is beneficial in this modified process due to the fact that ion beams may pass multiple times through a given volume of the diamond layer 104. Alternatively, an annealing step may be performed after graphite layers 106-1 and 106-3 have been formed, and then again after graphite layers 106-2 and 106-4 have been formed. Alternatively, a single annealing step may be performed after all four graphite layers have been formed.

In an embodiment, if the diamond layer 104 is not thick enough to receive the desired number of graphite layers (while accounting for the required dielectric thickness in between the graphite layers), epitaxy may be performed to grow the diamond layer 104, preferably before the first ion implantation step.

FIG. 4 illustrates a capacitor structure 400 according to a second embodiment. As shown in FIG. 4, capacitor structure 400 may include a substrate 102, a single-crystal diamond layer 103, a plurality of graphite layers 107 buried into the single-crystal diamond layer 103, and first and second electrode contacts 108.

In various aspects, e.g., as it relates to substrate 102, diamond layer 103, and electrode contacts 108, capacitor structure 400 may be similar or identical to capacitor structure 100. As such, the same embodiments and features described above with respect to capacitor structure 100 may equally apply to capacitor structure 400.

However, whereas capacitor structure 100 includes planar graphite layers 106 (i.e., each layer formed by multiple adjacent horizontal atomic planes), capacitor structure 400 includes what is referred to herein as "textured" graphite layers 107 as shown in FIG. 4. As would be understood by a person of skilled in the art based on the teachings herein, textured graphite layers according to embodiments are not limited to the example shape provided in FIG. 4 and may take any non-planar shape consistent with aspects of the present invention.

By using textured graphite layers, the resulting capacitance specific surface can be increased. Higher capacitance density can thus be obtained for each given implantation step. This gain can be particularly significant when the diamond regions intervening between consecutive graphite layers 107 are made thinner relative to the dimensions of the 3D texture of the graphite layers 107.

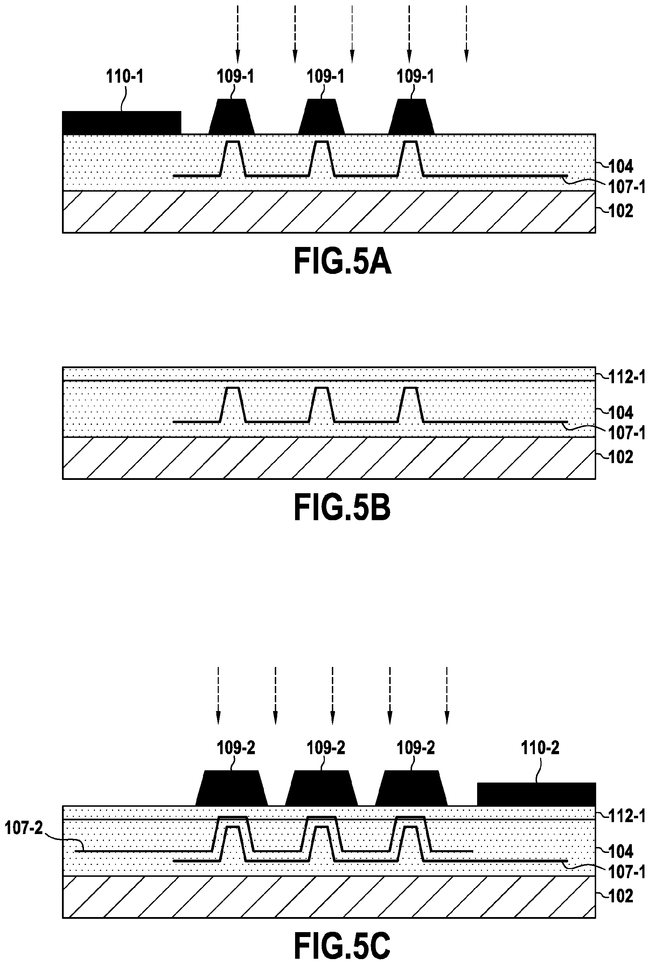

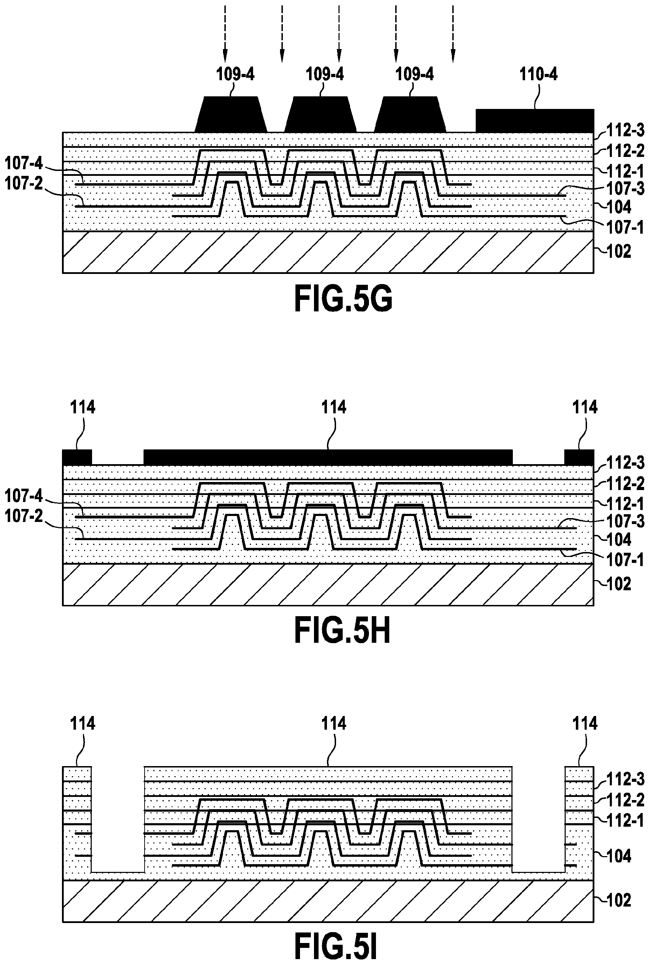

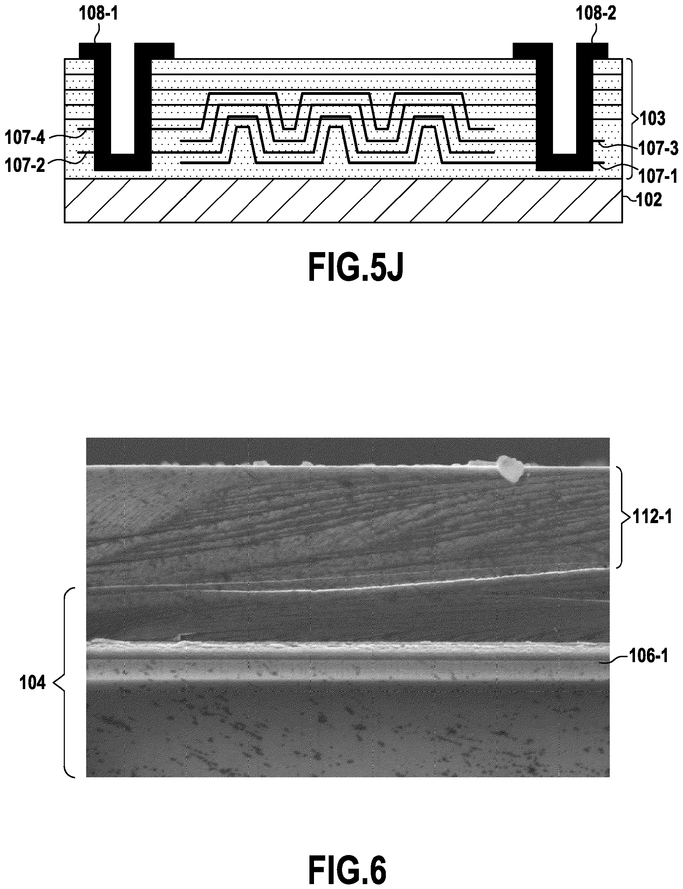

FIG. 5A-5J illustrate an example process that may be used to fabricate the capacitor structure 400.

As shown in FIG. 5A, starting with the intermediate structure described with reference to FIG. 2B above (optionally with the first mask layer 110-1), the process may include forming a first textured (i.e., having a varying thickness) mask layer 109-1 over the first single-crystal diamond layer 104, and performing an ion implantation process to implant first ions (e.g., hydrogen, helium, or carbon) into the diamond layer 104 to form a first graphite layer 107-1 inside the diamond layer 104. It is noted that, unlike mask layers 110, the mask layer 109-1 is one that attenuates, but does not fully block, the beamed ions. The mask layer 109-1 may be of similar material as mask layer 110-1 but made thinner so as not to be fully-blocking. Alternatively, the mask layer 109-1 may be a softer material compared to the material of the first mask layer 110-1 (e.g., a polymer as compared to a mineral (e.g., Si3N4)/metal for the first mask layer 110-1).

Due to the textured shape of the first mask layer 109-1, the resulting first graphite layer 107-1 is also textured as shown.

In an embodiment, the process may include, after the ion implantation process, an annealing process to heal the damage caused by the ion implantation. In an embodiment, the annealing process is a high-temperature process (e.g., at a temperature greater than 1100°C).

Next, as shown in FIG. 5B, and as described above with reference to FIG. 2C, the process includes epitaxially growing a second single-crystal diamond layer 112-1 on top of the first single-crystal diamond layer 104.

Subsequently, as shown in FIG. 5C, a second textured mask layer 109-2 (and optionally a second planar mask layer 110-2) is formed over the second diamond layer 112-1, an ion implantation process is performed to implant second ions (e.g., hydrogen, helium, or carbon) into first single-crystal diamond layer 104 and/or the second single-crystal diamond layer 112-1 to form a second graphite layer 107-2 inside the first single-crystal diamond layer 104 and/or the second single-crystal diamond layer 112-1.

In an embodiment, as shown in FIG. 5C, the second graphite layer 107-2 is formed so as to conformally englobe the first graphite layer 107-1. The thickness of the diamond intervening between the first and second graphite layers 107-1 and 107-2 may be varied as desired. However, as mentioned above, to increase capacitance density, the intervening diamond should be made as thin as possible. A person of skill in the art would recognize that the second mask layer 109-2 must be configured appropriately in order for the second graphite layer 107-2 to conformally englobe the first graphite layer 107-1. For example, as shown in FIG. 5C, the second mask layer 109-2 may be obtained by horizontally stretching the first mask layer 109-1, but keeping the same horizontal alignment and 3D dimensions (i.e., height).

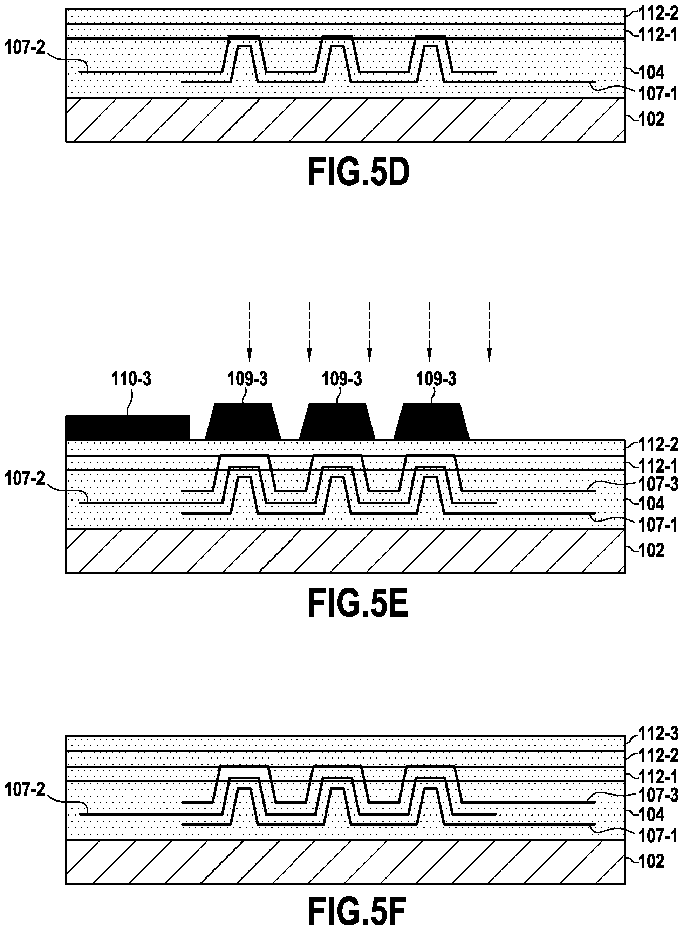

The process may then continue as shown in FIGs. 5D-5G to form further graphite layers 107-3 and 107-4 in the structure.

Specifically, after an optional annealing step as described above, a third single-crystal diamond layer 112-2 may be epitaxially grown above the second diamond layer 112-1 as shown in FIG. 5D, and a third graphite layer 107-3 may then be formed by ion implantation inside the first diamond layer 104, the second diamond layer 112-1 and/or the third diamond layer 112-2 as shown in FIG. 5E.

An optional third mask layer 110-3 may be used in the formation of third graphite layer 107-3. The third mask layer 110-3 may be similar in shape and relative positioning to the first mask layer 110-1 used in forming the first graphite layer 107-1.

The same process (annealing, epitaxy, and ion implantation) may then be repeated as shown in FIGs. 5F and 5G to form a fourth graphite layer 107-4 inside the first diamond layer 104, the second diamond layer 112-1, the third diamond layer 112-2, and/or a further epitaxially-grown fourth diamond layer 112-3 as shown in FIG. 5G.

An optional fourth mask layer 110-4 may be used in the formation of fourth graphite layer 107-4. The fourth mask layer 110-4 may be similar in shape and relative positioning to the second mask layer 110-2 used in forming the second graphite layer 106-2.

The formed graphite layers 107 may be interconnected in a similar manner as discussed above with respect to graphite layers 106 and as shown in the example process steps show in FIGs. 5H-5J, for example.

FIG. 6 is a scanning electron microscopy (SEM) image showing a single-crystal diamond structure with a graphite layer buried therein by ion implantation. As shown, the structure comprises a first single-crystal diamond layer 104 and a second single-crystal diamond layer 112-1.

The diamond layer 104 is provided by a pristine CVD diamond layer. The second diamond layer 112-1 is epitaxially-grown over the first diamond layer 104.

The graphite layer 106-1 is formed inside the first diamond layer 104, after a high-temperature annealing and before the growing of the second diamond layer 112-1. As shown, the graphite layer 106-1 is formed by multiple atomic planes giving it a certain thickness.

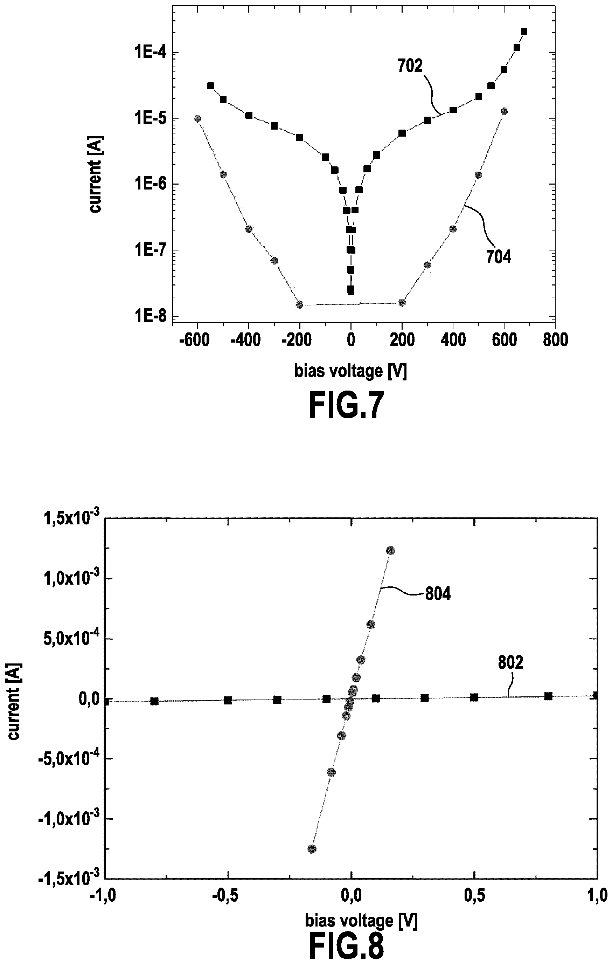

FIG. 7 illustrates the effect of the application of the above-described annealing process on the dielectric properties of the single-crystal diamond structure of FIG. 6. Particularly, FIG. 7 shows the leakage current through the first diamond layer 104 (after ion implantation) as a function of a bias voltage applied across the layer 104. The curve 702 corresponds to the case where no annealing has been applied and the curve 704 corresponds to the case where annealing has been applied.

As shown, the application of the annealing drastically reduces the leakage current (by a factor of 1000 for certain bias voltage values) through the first diamond layer 104. In other words, the annealing process returns the diamond layer 104, which has been damaged by the ion implantation, substantially to its intrinsic state. The desirable dielectric properties of the intrinsic diamond are thereby regained.

FIG. 8 illustrates the effect of the application of the above-described annealing process on the resistance of the graphite layer 106-1 buried in the single-crystal diamond structure of FIG. 6. Particularly, FIG. 8 shows the current through first graphite layer 106-1 as a function of a bias voltage applied across the layer 104. The curve 802 corresponds to the case where no annealing has been applied and the curve 804 corresponds to the case where annealing has been applied.

As shown, in both cases, the current through the graphite layer 106-1 is linear as a function of the applied voltage. This indicates that the graphite layer 106-1, while conductive, provides an amount of resistance. The resistance of the graphite layer 106-1 decreases with the application of the annealing as shown in FIG. 8. As such, the annealing advantageously increases the conductivity of the graphite layers which form the electrodes of the capacitor structure.

With a higher value resistance, the graphite layer 106-1 provides a resistive electrode, highly suited for RC circuit applications, for example.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. A capacitor structure (100, 400), comprising:
a single-crystal diamond layer (103);
a first graphite layer (106-1, 107-1) buried into the single-crystal diamond layer (103), the first graphite layer (106-1, 107-1) providing a first electrode of the capacitor structure (100, 400); and
a second graphite layer (106-2, 107-2) buried into the single-crystal diamond layer (103), above the first graphite layer (106-1, 107-1), the second graphite layer (106-2, 107-2) providing a second electrode of the capacitor structure (100, 400).

2. The capacitor structure (100, 400) of claim 1, comprising:
a substrate (102) supporting the single-crystal diamond layer (103).

3. The capacitor structure (100, 400) of claim 2, wherein the substrate (102) is conductive and electrically connected to the first graphite layer (106-1, 107-1) or to the second graphite layer (106-2, 107-2).

4. The capacitor structure (100, 400) of claim 2, wherein the substrate (120) is a silicon-based substrate, a gallium nitride substrate, or a diamond substrate.

5. The capacitor structure (100, 400) of any of claims 1-4, wherein the first graphite layer (106-1, 107-1) and the second graphite layer (106-2, 107-2) are planar.

6. The capacitor structure (100, 400) of any of claims 1-4, wherein the first graphite layer (106-1, 107-1) and second graphite layer (106-2, 107-2) are textured.

7. The capacitor structure (100, 400) of any of claims 1-6, wherein the single-crystal diamond layer (103) comprises an epitaxial diamond layer (112-1), and wherein the second graphite layer (106-2, 107-2) is at least partially buried into the epitaxial diamond layer (112-1).

8. The capacitor structure (100, 400) of any of claims 1-7, further comprising:
a third graphite layer (106-3, 107-3) buried into the single-crystal diamond (103) layer above the second graphite layer (106-2, 107-2); and
a fourth graphite layer (106-4, 107-4) buried into the single-crystal diamond layer (103) above the third graphite layer (106-3, 107-3).

9. The capacitor structure (100, 400) of claim 8, wherein the third graphite layer (106-3, 107-3) is electrically connected to the first graphite layer (106-1, 107-1) and the fourth graphite layer (106-4, 107-4) is electrically connected to the second graphite layer (106-2, 107-2).

10. The capacitor structure (100, 400) of claim 8, wherein the first graphite layer (106-1, 107-1) and the fourth graphite layer (106-4, 107-4) are electrically connected.

11. A capacitor structure (100, 400), comprising:
a single-crystal diamond layer (103);
a graphite layer (106-1) buried into the single-crystal diamond layer (103), the graphite layer (106-1) providing a first electrode of the capacitor structure (100, 400); and
a conductive substrate (102) supporting the single-diamond layer (103) providing a second electrode of the capacitor structure (100, 400).

12. A method of fabricating a capacitor structure (100, 400), comprising:
implanting first ions into a first single-crystal diamond layer (104) to form a first graphite layer (106-1, 107-1) inside the first single-crystal diamond layer (104);
subjecting the ion-implanted first single-crystal diamond layer (104) to an annealing process;
epitaxially growing a second single-crystal diamond layer (112-1) on top of the first single-crystal diamond layer (104); and
implanting second ions into first single-crystal diamond layer (104) and/or the second single-crystal diamond layer (112-1) to form a second graphite layer (106-2, 107-2) inside the first single-crystal diamond layer (104) and/or the second single-crystal diamond layer (112-1).

13. The method of claim 12, wherein the annealing process comprises subjecting the ion-implanted first single-crystal diamond layer (104) to a temperature of at least 1100°C.

14. A method of fabricating a capacitor structure (100, 400), comprising:
forming a first mask layer (110-1) over a first end region of a first single-crystal diamond layer (104);
implanting first ions, using a first energy level, into the first single-crystal diamond layer (104) to form a first graphite layer (106-1, 107-1) inside the first single-crystal diamond layer (104);
implanting second ions, using a second energy level lower than the first energy level, into the first single-crystal diamond layer (104) to form a second graphite layer (106-3, 107-3), above the first graphite layer (106-1, 107-1), inside the first single-crystal diamond layer (104); and
electrically connecting the first graphite layer (106-1, 107-1) and the second graphite layer (106-3, 107-3).

15. The method of claim 14, comprising subjecting the ion-implanted first single-crystal diamond layer (104) to an annealing process.
